# FASCICULE DE BREVET EUROPEEN

(11) **EP 2 145 854 B1**
(45) Date de publication et mention de la délivrance du brevet: **29.08.2018**
(21) Numéro de dépôt: 09165609.0
(22) Date de dépôt: 16.07.2009
(51) Int. Cl.: B81B 7/00

(54) **Dispositif MEMS comportant une interface electro-mécanique à base de nanotubes entre un composant et son support**
MEMS-Vorrichtung mit einer elektromechanischen Schnittstelle auf Nanoröhrenbasis zwischen einen Komponenten und dessen Träger
MEMS device comprising an electro-mecanical nanotube-based interface between a component and its support

(30) Priorité: 18.07.2008 FR 0804114
(43) Date de publication de la demande: 20.01.2010
(73) Titulaire: THALES, 92400 Courbevoie (FR)
(72) Inventeur: Parbaud, Serge, 26320 Saint Marcel Les Valence (FR); Sarno, Claude, 26800 Étoile/Rhône (FR)
(74) Mandataire: Esselin, Sophie

(56) Documents cités:
- WO-A-2006/048846

## Description

Le domaine de l'invention est celui des dispositifs électromécaniques et notamment celui des dispositifs comportant des capteurs de type gyromètres ou accéléromètres destinés à pouvoir être embarqués dans des engins ou des munitions et susceptibles d'être soumis à de très fortes contraintes tant thermiques que mécaniques.

Généralement, de tels composants sont reportés sur un substrat par l'intermédiaire d'une cale sur laquelle ces composants sont collés.

Ils peuvent également être reportés par brasure directe sur le substrat ou sur le boîtier d'encapsulation.

Ces éléments d'interface comportent le plus souvent des limitations en terme de vibrations, d'expansion thermique ou bien encore en terme de résistances aux chocs. De plus ils ont tendance à introduire des biais qui génèrent des dérives au niveau des composants de type capteurs représentant par la même un problème en terme de fiabilité.

WO 2006/048846 divulgue un dispositif dans lequel une interface mécanique, électrique et thermique entre un composant et un substrat est réalisée avec un matériau comprenant des nanotubes de carbone.

Dans ce contexte, la présente invention a pour objet un dispositif électro-mécanique permettant de reporter ces composants en limitant les contraintes d'origine mécanique ou thermique, dans lequel les composants électroniques sont rapportés à un support par l'intermédiaire de nanotubes de carbone ou de structures à base de nanotubes de carbone, dont on peut exploiter les performances aussi bien en terme d'excellente résistance mécanique qu'en terme de très bonne conductivité thermique et électrique.

Plus précisément l'invention a pour objet un dispositif électro-mécanique selon la revendication 1, comportant un boîtier qui comprend un substrat de fond, des murs latéraux et un support secondaire, le composant électronique étant rapporté mécaniquement via une interface à base de nanotubes au niveau du support secondaire.

L'invention a également pour objet un procédé de fabrication d'un tel dispositif selon la revendication 13.

Des modes de réalisation particuliers font l'objet des revendications dépendantes.

L'invention sera mieux comprise et d'autres avantages apparaîtront à la lecture de la description qui va suivre donnée à titre non limitatif et grâce aux figures annexées parmi lesquelles :
- les figures 1a et 1b illustrent des réalisations qui ne relèvent pas de l'invention, dans lesquelles l'interface à base de nanotubes assure une fonction mécanique ;
- la figure 2 schématise une variante de l'invention comportant un support intermédiaire de report ;
- la figure 3a illustre une réalisation qui ne relève pas de l'invention, dans laquelle l'interface à base de nanotubes assure une liaison mécanique et une liaison électrique ;
- la figure 3b schématise une variante de l'invention, dans laquelle l'interface à base de nanotubes assure une liaison mécanique et une liaison électrique ;
- la figure 4 illustre les étapes d'un procédé de collage par polymère chargé de particules conductrices pouvant avantageusement être utilisé dans un procédé de fabrication d'un dispositif selon l'invention ;
- les figures 5a et 5b illustrent des réalisations qui ne relèvent pas de l'invention, comprenant un boîtier comportant des composants de type MEMS.

Les avantages des nanotubes et plus particulièrement des nanotubes de carbone dénommés ci-après à partir de la terminologie anglo-saxonne : Carbon Nanotubes, « CNT » résident notamment dans les propriétés suivantes qu'ils possèdent :
- un module d'Young de l'ordre de 1 TPa ;
- une très forte résistance mécanique de l'ordre de 100 GPa ;
- une très bonne conductivité électrique.

Différentes variantes de l'invention vont être décrites à l'aide de schémas simplifiés qui représentent les interfaces à base de nanotubes. Ces interfaces peuvent être obtenues par croissance de nanotubes à la surface d'un composant selon des techniques de l'art connu ou par report via des techniques de brasage ou de collage.

Elles peuvent également être réalisées à partir de solutions dans lesquelles sont dispersées des nanotubes, ces solutions pouvant être enduites à la surface du composant avant que le report de ce dernier au niveau d'un substrat soit effectué.

Plus précisément, on procède à l'enduction du substrat par une solution renfermant des nanotubes de carbone. Cette opération est réalisée à température ambiante, contrairement aux opérations de croissance de nanotubes effectuée à température plus élevée. Il s'agit donc d'une opération non agressive qui permet de plus une très bonne répartition des éléments assurant la conduction thermique à la surface de tous les composants électroniques.

Typiquement pour réaliser la solution de nanotubes, on peut utiliser des solvants de type DiMéthyl-Méthyl-Formamide (DMF) ou DiChlore-Ethane (DCE) ou N-Méthyl-2-pyrrolidone (NMP) ou DiChloro-Benzene (DCB) ou Eau+ Dodécylsulfate de sodium (SDS).

La méthode utilisée pour obtenir une dispersion optimale peut être la suivante :
- l'ajout d'environ 1mg de nanotubes de carbone dans 20 ml de solvant (ces valeurs sont purement indicatives et par conséquence les quantités sont modulées et optimisées pour obtenir la conductivité thermique souhaitée).
- l'emploi d'un appareil qui envoie des ultra-sons appelé sonificateur par intermittence pour « sonifier » ladite solution. En effet les ultra-sons aident à désolidariser les cordes de nanotubes qui ont tendance à se former en raison de forces de Van Der Walls.
- la centrifugation de la solution au sein d'un récipient de manière à retenir en fond de récipient toutes les cordes non-désolidarisées lors de la sonification, et les autres formes d'impuretés, par exemple des résidus des catalyseurs métalliques.

La solution ainsi obtenue peut alors être déposée de manière classique à la surface du substrat comportant les composants électroniques.

Typiquement on peut procéder à l'enduction d'une solution par pulvérisation avec un spray de solution ou avec des microgouttes ou avec une machine à jet d'encre.

Après évaporation du solvant, on obtient un tapis de nanotubes répartis de manière aléatoire.

Afin d'améliorer les propriétés de conductivité thermique du tapis de nanotubes de carbone formés à la surface des composants électroniques, on peut également employer des techniques permettant de faire de l'enduction dirigée.

Pour cela on peut avoir recours à des techniques telles que l'électrophorèse, l'utilisation d'un champ magnétique, le dépôt puis séchage sous flux de gaz dirigé,....

Selon la présente invention, il est ainsi proposer d'utiliser une interface à base de ce type de nano-matériaux pour permettre d'obtenir un composant avec moins de contraintes thermiques et susceptible de recevoir des signaux nécessaires à sa commande, de très bonne qualité.

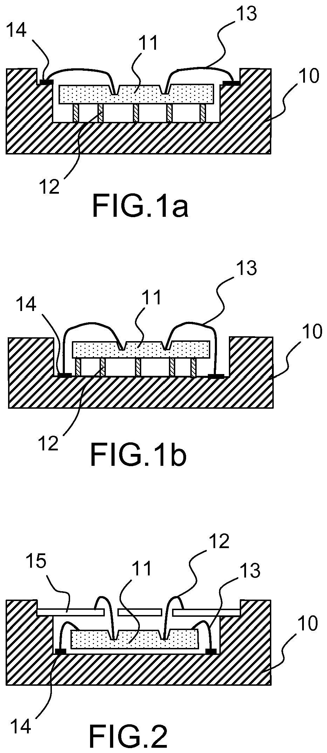

Selon une réalisation qui ne relève pas de l'invention, illustrée en figure 1a, un composant électronique 11 est reporté sur un substrat 10 pouvant faire partie intégrante d'un boîtier, par l'intermédiaire d'une interface de nanotubes 12, assurant une fonction de report mécanique. L'adressage électrique du composant est réalisé par l'intermédiaire d'éléments conducteurs classiques 13 connectés par ailleurs à des plots de connexion 14 dont est équipé le boîtier. En variante, et comme illustré en figure 1b, les plots de connexion 14 peuvent être situés au niveau du fond du boîtier, soit au niveau du substrat.

Selon l'invention et comme illustré en figure 2, le dispositif est équipé d'un support secondaire 15, auquel est rapporté mécaniquement le composant électronique 11, l'interface mécanique constituée par les nanotubes est ainsi réalisée entre ledit support intermédiaire et le composant. Le boîtier comporte dans ce cas un plan intermédiaire au niveau duquel est positionné le support intermédiaire. On exploite ainsi les très bonnes propriétés mécaniques des nanotubes.

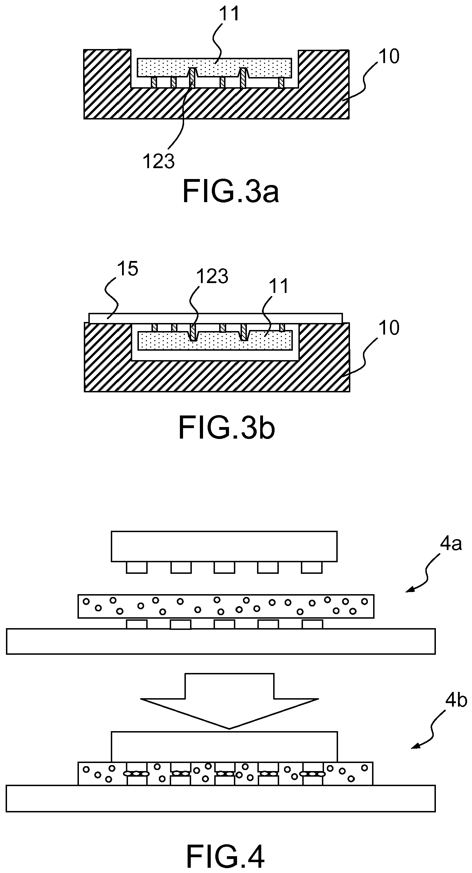

Il est également possible d'exploiter simultanément leurs propriétés électriques. La figure 3a qui ne relève pas de l'invention, est ainsi relative à un dispositif utilisant des nanotubes assurant à la fois la fonction de report mécanique et de liaison électrique. Selon cette variante, le composant 11 est relié mécaniquement et électriquement au boîtier intégrant un substrat 10, via une interface 123 de nanotubes.

La figure 3b illustre cette variante pour une configuration selon l'invention, utilisant un support intermédiaire 15 de type circuit imprimé.

Avantageusement, le composant sur lequel est au préalable réalisée l'interface de nanotubes, peut-être mis en contact avec un substrat par l'intermédiaire d'une colle conductrice telle qu'une colle de type ACAs.

Pour assurer cette liaison, on procède dans une première étape 4a à l'enduction d'une solution de monomère renfermant des particules conductrices à la surface du substrat, comme illustré en figure 4.

Dans une seconde étape 4b, on procède à la polymérisation du monomère par application d'une pression ou par élévation de température, de manière à réaliser la couche de colle conductrice à base de polymère renfermant des particules conductrice.

Il est à noter que le report d'un composant au niveau du boîtier peut nécessiter un report sur une surface dudit composant présentant différents niveaux. Il convient pour cela de réaliser une interface présentant des nanotubes de longueur variable.

La présente invention a été décrite de manière très schématisée dans le cadre d'un composant reporté dans un boîtier.

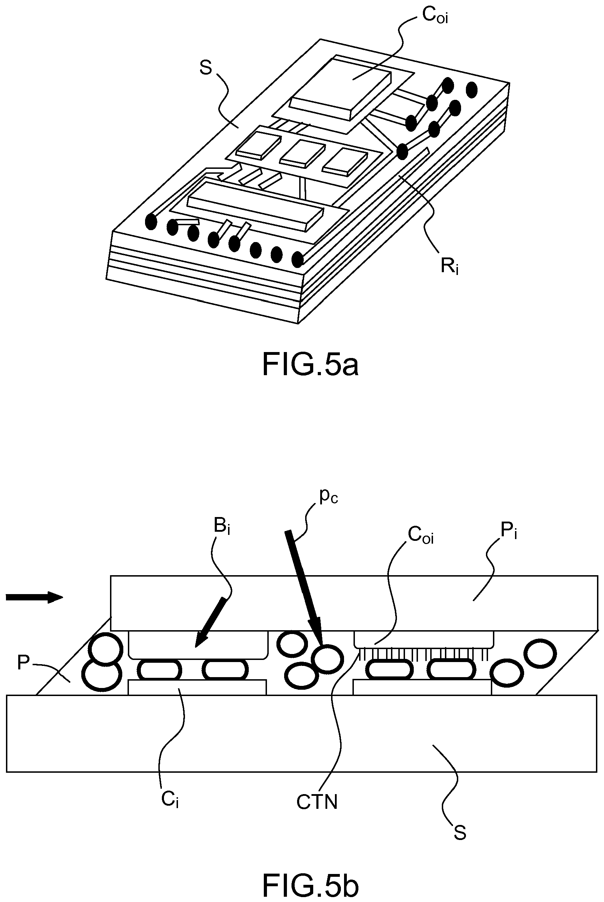

De manière usuelle, le boîtier employé renferme une série de composants Coi en fond de boîtier avec un réseau de connexions Ri comme illustré en figure 5a.

La figure 5b est relative à une vue en coupe d'un des composants Coi. Avantageusement, le composant comporte une interface à base de nanotubes, reporté sur le fond de boîtier à l'aide d'une colle conductrice telle que celle dont le procédé d'élaboration est représenté en figure 4.

Ainsi à la surface d'un substrat S, équipé de contacts Ci appartenant au réseau de connexions Ri, est assuré un report mécanique et électrique d'un composant Coi monté sur une puce Pi.

L'interface de nanotubes CTN est relié audit substrat par l'intermédiaire d'un polymère P comportant des particules conductrices pc.

De manière générale, les composants employés peuvent être à base de silicium ou de tout autre matériaux semi-conducteurs.

Les boîtiers employés peuvent être de nature très diverse et notamment de type silice, céramique, ....

## Revendications

1. Dispositif électro-mécanique comportant un boîtier, ledit boîtier comprenant un support (10) et au moins un composant (11), **caractérisé en ce qu'**il comporte en outre un support secondaire (15) et des murs latéraux, ledit support (10) et ledit support secondaire (15) étant séparés par lesdits murs latéraux, une interface mécanique ou électro-mécanique de filtrage vibratoire et thermique à base de nanotubes (12) assurant la liaison entre ledit composant (11) et le support secondaire (15) et permettant au dit composant (11) d'être rapporté mécaniquement au support secondaire (15).

2. Dispositif électro-mécanique selon la revendication 1, **caractérisé en ce que** les nanotubes sont des nanotubes de carbone.

3. Dispositif électro-mécanique selon l'une des revendications 1 ou 2, **caractérisé en ce que** le support comprenant en outre des contacts électriques permettant d'adresser électriquement ledit composant, l'interface à base de nanotubes assure une fonction d'interface mécanique et électrique.

4. Dispositif électro-mécanique selon l'une des revendications 1 ou 2, **caractérisé en ce que** le support comprenant en outre des contacts électriques permettant d'adresser électriquement ledit composant, l'interface à base de nanotubes assure une fonction d'interface mécanique et électrique et thermique.

5. Dispositif électro-mécanique selon l'une des revendications 1 à 4, **caractérisé en ce que** l'interface est constituée d'un film de nanotubes.

6. Dispositif électro-mécanique selon l'une des revendications 1 à 5, **caractérisé en ce que** l'interface est constituée d'une couche de nanotubes orientés.

7. Dispositif électro-mécanique selon l'une des revendications 1 à 6, **caractérisé en ce qu'**il comprend en outre des éléments de colle permettant d'assurer la liaison de l'interface avec le composant et avec le support secondaire.

8. Dispositif électro-mécanique selon l'une des revendications 1 à 7, **caractérisé en ce qu'**il comprend en outre des éléments de brasage permettant d'assurer la liaison de l'interface avec le composant et avec le support secondaire.

9. Dispositif électro-mécanique selon la revendication 7, ou la revendication 8 lorsqu'elle dépend de la revendication 7, **caractérisé en ce que** la colle est de type polymère à base de particules conductrices (ACAs).

10. Dispositif électro-mécanique selon l'une des revendications 4 à 9, **caractérisé en ce que** le boîtier comprenant en outre des contacts électriques permettant d'adresser électriquement ledit composant, l'interface à base de nanotubes assure une fonction d'interface mécanique et électrique.

11. Dispositif selon l'une des revendications 1 à 10, **caractérisé en ce que** le composant est de type micro-système mécanique (MEMS).

12. Dispositif selon l'une des revendications 1 à 10, **caractérisé en ce que** le composant est de type capteur inertiel.

13. Procédé de fabrication d'un dispositif selon l'une des revendications 1 à 12, **caractérisé en ce qu'**il comporte les étapes suivantes :
- la réalisation d'une interface à base de nanotubes à la surface d'un composant ;
- le report côté interface de nanotubes, du composant sur un support secondaire.

14. Procédé de fabrication selon la revendication 13, **caractérisé en ce que** le report est effectué par collage.

15. Procédé de fabrication selon la revendication 14, **caractérisé en ce que** la colle est à base de polymère renfermant des particules conductrices.

## Patentansprüche

1. Elektromechanische Vorrichtung, beinhaltend ein Gehäuse, wobei das Gehäuse einen Träger (10) und mindestens eine Komponente (11) umfasst, **dadurch gekennzeichnet, dass** es zudem einen sekundären Träger (15) und seitliche Wände beinhaltet, wobei der Träger (10) und der sekundäre Träger (15) durch die Seitenwände getrennt sind, wobei eine mechanische oder elektromechanische Schwingungs- und Thermik-Filterschnittstelle auf Nanoröhrenbasis (12) die Verbindung zwischen der Komponente (11) und dem sekundären Träger (15) gewährleistet und es der Komponente (11) ermöglicht, mechanisch an dem sekundären Träger (15) angesetzt zu werden.

2. Elektromechanische Vorrichtung nach Anspruch 1, **dadurch gekennzeichnet, dass** die Nanoröhren Kohlenstoff-Nanoröhren sind.

3. Elektromechanische Vorrichtung nach einem der Ansprüche 1 oder 2, **dadurch gekennzeichnet, dass** der Träger zudem elektrische Kontakte beinhaltet, welche es ermöglichen, die Komponente elektrisch zu adressieren, wobei die Schnittstelle auf Nanoröhrenbasis eine mechanische und elektrische Schnittstellenfunktion gewährleisten.

4. Elektromechanische Vorrichtung nach einem der Ansprüche 1 oder 2, **dadurch gekennzeichnet, dass** der Träger zudem elektrische Kontakte beinhaltet, welche es ermöglichen, die Komponente elektrisch zu adressieren, wobei die Schnittstelle auf Nanoröhrenbasis eine mechanische und elektrische und thermische Schnittstellenfunktion gewährleistet.

5. Elektromechanische Vorrichtung nach einem der Ansprüche 1 bis 4, **dadurch gekennzeichnet, dass** die Schnittstelle aus einem Nanoröhrenfilm besteht.

6. Elektromechanische Vorrichtung nach einem der Ansprüche 1 bis 5, **dadurch gekennzeichnet, dass** die Schnittstelle aus einer Schicht aus ausgerichteten Nanoröhren besteht.

7. Elektromechanische Vorrichtung nach einem der Ansprüche 1 bis 6, **dadurch gekennzeichnet, dass** sie zudem Klebstoffelemente beinhaltet, welche dazu dienen, die Verbindung der Schnittstelle mit der Komponente und mit dem sekundären Träger zu gewährleisten.

8. Elektromechanische Vorrichtung nach einem der Ansprüche 1 bis 7, **dadurch gekennzeichnet, dass** sie zudem Lötelemente beinhaltet, welche dazu dienen, die Verbindung der Schnittstelle mit der Komponente und mit dem sekundären Träger zu gewährleisten.

9. Elektromechanische Vorrichtung nach Anspruch 7, oder nach Anspruch 8 in Abhängigkeit von Anspruch 7, **dadurch gekennzeichnet, dass** der Klebstoff ein Klebstoff vom Typ Polymerklebstoff auf der Grundlage von leitfähigen Partikeln (ACAs) ist.

10. Elektromechanische Vorrichtung nach einem der Ansprüche 4 bis 9, **dadurch gekennzeichnet, dass**, da das Gehäuse zudem elektrische Kontakte beinhaltet, welche es ermöglichen, die Komponente elektrisch zu adressieren, die Schnittstelle auf Nanoröhrenbasis eine mechanische und elektrische Schnittstellenfunktion gewährleistet.

11. Vorrichtung nach einem der Ansprüche 1 bis 10, **dadurch gekennzeichnet, dass** die Komponente eine Komponente vom Typ mechanisches Mikrosystem (MEMS) ist.

12. Vorrichtung nach einem der Ansprüche 1 bis 10, **dadurch gekennzeichnet, dass** die Komponente eine Komponente vom Typ Trägheitssensor ist.

13. Herstellungsverfahren einer Vorrichtung nach einem der Ansprüche 1 bis 12, **dadurch gekennzeichnet, dass** es folgende Schritte beinhaltet:
- Schaffung einer Schnittstelle auf Nanoröhrenbasis an der Oberfläche einer Komponente;
- schnittstellenseitiger Transfer von Nanoröhren, von der Komponente auf einen sekundären Träger.

14. Herstellungsverfahren nach Anspruch 13, **dadurch gekennzeichnet, dass** der Transfer durch Kleben erfolgt.

15. Herstellungsverfahren nach Anspruch 14, **dadurch gekennzeichnet, dass** der Klebstoff ein Klebstoff auf Polylmerbasis ist, welcher leitfähige Partikel enthält.

## Claims

1. Electromechanical device comprising a package, said package comprising a support (10) and at least one component (11), **characterised in that** it further comprises a secondary support (15) and lateral walls, said support (10) and said secondary support (15) being separated by said lateral walls, a mechanical or electromechanical interface for vibrational and thermal filtering based on nanotubes (12) providing the link between said component (11) and the secondary support (15) and allowing for said component (11) to be related mechanically to the secondary support (15).

2. Electromechanical device according to claim 1, **characterised in that** the nanotubes are carbon nanotubes.

3. Electromechanical device according to one of claims 1 or 2, **characterised in that** the support further comprising electrical contacts for electrically addressing said component, the nanotube-based interface provides a mechanical and electrical interface function.

4. Electromechanical device according to one of claims 1 or 2, **characterised in that** the support further comprising electrical contacts for electrically addressing said component, the nanotube-based interface provides a mechanical and electrical and thermal interface function.

5. Electromechanical device according to one of claims 1 to 4, **characterised in that** the interface is constituted of a film of nanotubes.

6. Electromechanical device according to one of claims 1 to 5, **characterised in that** the interface is constituted of a layer of oriented nanotubes.

7. Electromechanical device according to one of claims 1 to 6, **characterised in that** it further comprises adhesive elements for providing a link of the interface with the component and with the secondary support.

8. Electromechanical device according to one of claims 1 to 7, **characterised in that** it further comprises soldering elements for providing a link of the interface with the component and with the secondary support.

9. Electromechanical device according to claim 7, or claim 8 when it depends on claim 7, **characterised in that** the adhesive is of polymer-type based on conductive particles (ACAs).

10. Electromechanical device according to one of claims 4 to 9, **characterised in that** the package further comprising electrical contacts for electrically addressing said component, the nanotube-based interface provides a mechanical and electrical interface function.

11. Device according to one of claims 1 to 10, **characterised in that** the component is of mechanical microsystem type (MEMS).

12. Device according to one of claims 1 to 10, **characterised in that** the component is of inertial sensor type.

13. Manufacturing method for a device according to one of claims 1 to 12, **characterised in that** it comprises the following steps:
- the production of a nanotube-based interface on the surface of a component;
- the transfer on the nanotube interface side, of the component to a secondary support.

14. Manufacturing method according to claim 13, **characterised in that** the transfer is implemented using adhesive.

15. Manufacturing method according to claim 14, **characterised in that** the adhesive is based on polymer containing conductive particles.
